# EUROPÄISCHE PATENTSCHRIFT

(11) **EP 2 452 436 B1**
(45) Veröffentlichungstag und Bekanntmachung des Hinweises auf die Patenterteilung: **25.11.2015**
(21) Anmeldenummer: 10730151.7
(22) Anmeldetag: 01.07.2010
(51) Int. Cl.: H03K 19/0175, G06F 13/40, G06F 13/364, H03K 19/003

(54) **ELEKTRISCHE SCHALTUNG ZUR ÜBERTRAGUNG VON SIGNALEN ZWISCHEN ZWEI MASTERN UND EINEM ODER MEHREREN SLAVES**
ELECTRICAL CIRCUIT FOR TRANSMITTING SIGNALS BETWEEN TWO MASTERS AND ONE OR MORE SLAVES
CIRCUIT ÉLECTRIQUE POUR LA TRANSMISSION DE SIGNAUX ENTRE DEUX MAÎTRES ET UN OU PLUSIEURS ESCLAVES

(30) Priorität: 10.07.2009 DE 102009027625
(43) Veröffentlichungstag der Anmeldung: 16.05.2012
(73) Patentinhaber: Robert Bosch GmbH, 70442 Stuttgart (DE)
(72) Erfinder: FRESE, Volker, 71717 Beilstein (DE)
(86) Internationale Anmeldenummer: PCT/EP2010/059342
(87) Internationale Veröffentlichungsnummer: WO 2011/003801

(56) Entgegenhaltungen:
- US-A- 5 127 089
- US-A- 5 418 933
- US-A- 6 070 205
- US-A1- 2004 267 992

## Beschreibung

### Stand der Technik

Die Erfindung betrifft eine elektrische Schaltung zur Übertragung von Signalen zwischen zwei Mastern und einem oder mehreren Slaves nach dem Oberbegriff des Anspruchs 1.

Bei elektronischen Schaltungen, insbesondere bei digitalen Schaltungen ist es bekannt, den Zugriff auf gemeinsame Komponenten der Schaltung mit Hilfe des sogenannten Master/Slave-Prinzips zu verwalten. So ist es möglich, dass ein Master, beispielsweise ein Mikroprozessor, mit einem oder mit zwei Slaves, beispielsweise mit zwei elektronischen Endstufen, über ein Bussystem verbunden ist. Der Master sendet ein Taktsignal, ein Master-Datensignal sowie ein Auswahlsignal. Mit dem Auswahlsignal wird einer der beiden Slaves als Empfänger ausgewählt. Dieser Slave empfängt das Datensignal im Takt des Taktsignals. Weiterhin kann der Slave ein Slave-Datensignal im Takt des empfangenen Taktsignals an den Master zurücksenden.

Da nur der Master das Auswahlsignal und das Taktsignal versenden kann, ist er den beiden Slaves übergeordnet. Ein Slave kann nur dann ein Datensignal an den Master übertragen, wenn der Master ihn zuvor mit dem Auswahlsignal ausgewählt hat. Der Zugriff auf die gemeinsame Komponente, also beispielsweise auf das den Master und die Slaves verbindende Bussystem, wird somit von dem Master verwaltet.

Bei elektronischen Steuergeräten beispielsweise im Kraftfahrzeugbereich ist es aus Gründen der Sicherheit häufig erforderlich, einen Mikroprozessor doppelt auszuführen, also einen sogenannten Backup-Prozessor vorzusehen. In diesem Fall müssen beide Mikroprozessoren als Master betreibbar sein und beide Master müssen über das Bussystem mit den Slaves verbindbar sein. Die erste Anforderung bedeutet, dass die Mikroprozessoren eine sogenannte Multi-Masterfähigkeit besitzen müssen, was üblicherweise mit einem erhöhten Aufwand verbunden ist. Die zweite Anforderung bringt das Problem mit sich, dass die beiden Mikroprozessoren beispielsweise ein Taktsignal versenden, so dass beispielsweise das von dem ersten Mikroprozessor erzeugte Taktsignal unter anderem auch gegen den Signalausgang getrieben wird, an dem der zweite Mikroprozessor sein Taktsignal versendet. Dies kann zur Schädigung oder Zerstörung von elektronischen Bauteilen dieses Signalausgangs führen.

Die Patentschrift US 6,070,205 A beschreibt ein Prozessorsystem, welches mehrere Bus-Master und wenigstens einen Bus-Slave umfasst, welche über einen gemeinsamen Datenbus miteinander verbunden sind. Der Zugriff der verschiedenen Bus-Master auf den Datenbus wird hierbei durch einen oder mehrere Bus-Arbitratoren organisiert. Diese empfangen von den Bus-Mastern Zugriffsanfragen und erteilen über entsprechende Signalleitungen die Erlaubnis für den Zugriff auf den Datenbus für einzelne Bus-Master.

Aufgabe der Erfindung ist es, eine elektrische Schaltung zu schaffen, mit der Signale zwischen zwei Mastern und einem oder mehreren Slaves übertragen werden können.

### Offenbarung der Erfindung

Die Erfindung löst diese Aufgabe durch eine elektrische Schaltung nach dem Anspruch 1.

Erfindungsgemäß sind die beiden Master und der oder die Slaves über ein Bussystem miteinander verbunden. Von den beiden Mastern ist jeweils zumindest ein Master-Datensignal erzeugbar, das von dem oder den Slaves empfangen werden kann. An den Ausgängen der beiden Master, an denen das jeweilige Master-Datensignal anliegt, ist jeweils ein Tri-State-Gatter vorhanden. Die Tri-State-Gatter sind entweder als geschlossene oder als geöffnete Schalter wirksam. Die Tri-State-Gatter werden derart angesteuert, dass das dem einen der beiden Master zugeordnete Tri-State-Gatter als geschlossener Schalter und das dem anderen der beiden Master zugeordnete Tri-State-Gatter als geöffneter Schalter wirkt.

Erfindungsgemäß wird somit die über das Bussystem vorhandene Verbindung zwischen den beiden Mastern durch eines der beiden Tri-State-Gatter unterbrochen. Damit hat das von einem der beiden Master erzeugte Master-Datensignal keinen Einfluss mehr auf den anderen Master. Eine Schädigung oder gar Zerstörung von Bauteilen in einem der Master ist damit nicht möglich. Dabei ist es jedoch nicht erforderlich, dass einer der beiden Master die erwähnte Multi-Masterfähigkeit besitzen müsste. Die der Erfindung gestellt Aufgabe wird daher mit einem geringen Aufwand insbesondere durch die Hinzufügung der Tri-State-Gatter gelöst.

In vorteilhafter Weise können auch diejenigen Ausgänge der beiden Master, auf denen ein Taktsignal anliegt, mit Tri-State-Gattern versehen werden.

Erfindungsgemäß werden die Tri-State-Gatter in Abhängigkeit von einem Anforderungssignal angesteuert, das von einem der beiden Master erzeugbar ist, wenn dieser Master Signale auf dem Bussystem übertragen will. Durch dieses Anforderungssignal kann erreicht werden, dass der anfordernde Master den Zugriff auf das Bussystem erhält und Signale über das Bussystem übertragen kann.

Erfindungsgemäß werden die Tri-State-Gatter in Abhängigkeit davon angesteuert, ob eine Übertragung auf dem Bussystem stattfindet oder nicht. Dies wird mit Hilfe von einem oder mehreren Auswahlsignalen festgestellt. Damit wird gewähr-leistet, dass eine Vergabe des Zugriffs auf das Bussystem nur dann möglich ist, wenn eine vorhergehende Übertragung auf dem Bussystem beendet ist.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung.

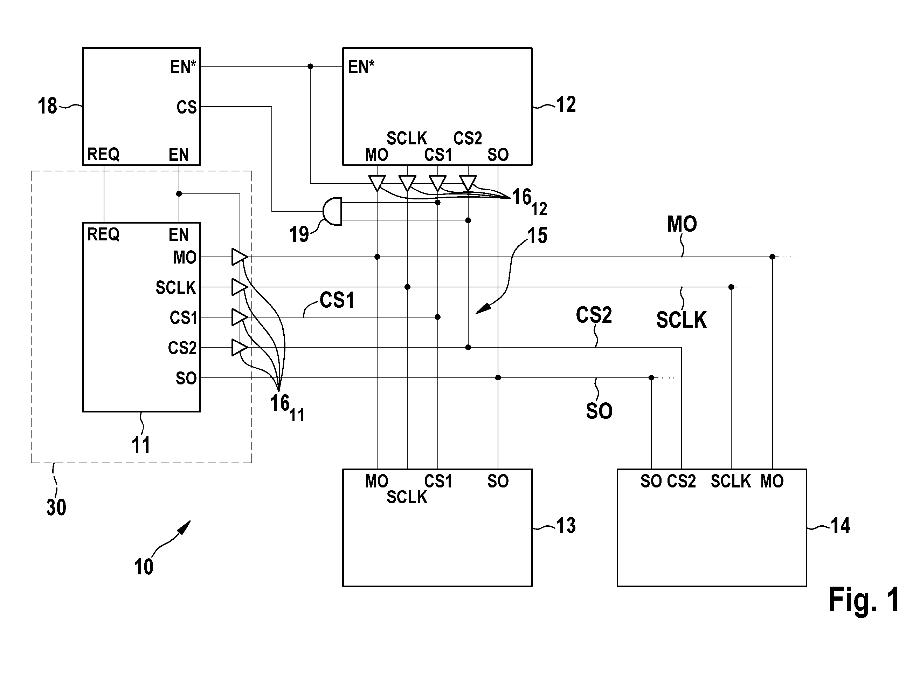

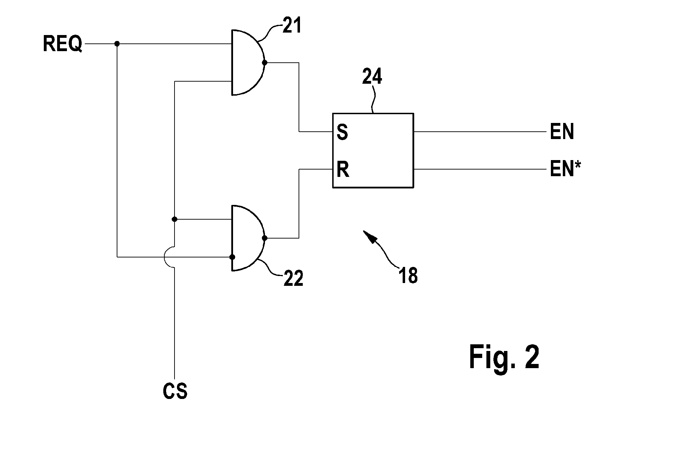

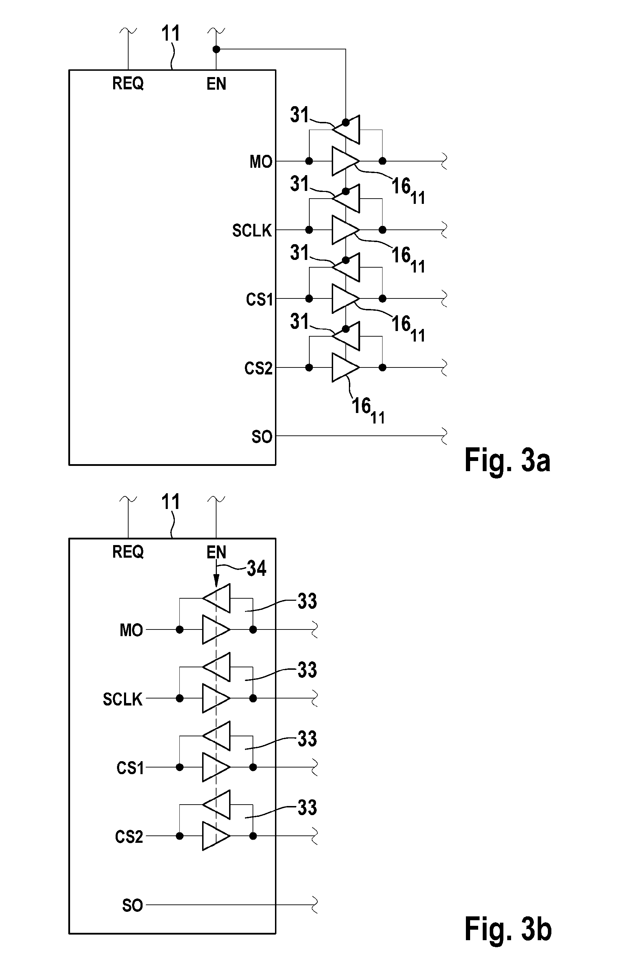

Figur 1 zeigt ein schematisches Blockschaltbild eines Ausführungsbeispiels einer erfindungsgemäßen elektrischen Schaltung zur Übertragung von Signalen zwischen zwei Mastern und zwei Slaves, Figur 2 zeigt ein detailliertes schematisches Blockschaltbild eines Ausführungsbeispiels für einen Schaltungsteil der Schaltung der Figur 1, und Figuren 3a, 3b zeigen Abwandlungen eines anderen Schaltungsteils der Schaltung der Figur 1.

Im Kraftfahrzeugbereich werden eine Vielzahl von elektronischen Steuergeräten eingesetzt. Die Steuergeräte dienen beispielsweise der Realisierung eines Antiblockiersystems für die Bremsanlage des Kraftfahrzeugs. In dem Steuergerät ist ein Mikroprozessor enthalten, der die Funktionen des Antiblockiersystems per Software ausführt. Das Steuergerät ist über ein Bussystem mit elektrischen Endstufen verbunden, die zur Steuerung von elektrisch betätigbaren Ventilen vorgesehen sind. Mit den Ventilen kann der auf eine Radbremse einwirkende Bremsdruck und damit die Bremskraft des Rads verändert werden.

Im Hinblick auf die Sicherheit des Kraftfahrzeugs ist es erforderlich, dass der Mikroprozessor, der in dem vorstehend beschriebenen, beispielhaften Steuergerät vorhanden ist, doppelt ausgeführt ist, so dass bei Ausfall des ersten Mikroprozessors dessen Funktionen von dem zweiten Mikroprozessor übernommen werden können.

In der Figur 1 ist eine elektrische Schaltung 10 dargestellt, die in dem vorstehenden Beispielfall zum Einsatz kommen kann. Die Schaltung 10 weist zwei sogenannte Master 11, 12 und zwei sogenannte Slaves 13, 14 auf. Bei den beiden Mastern 11, 12 kann es sich um die beiden genannten Mikroprozessoren und bei den beiden Slaves 13, 14 kann es sich um zwei Endstufen handeln. Es versteht sich, dass in der Schaltung der Figur 10 auch mehr als zwei Slaves 13, 14 vorhanden sein können oder auch nur ein einziger Slave vorhanden sein kann. Ebenfalls versteht es sich, dass es sich bei den Mastern 11, 12 und Slaves 13, 14 auch um andere elektronische Komponenten einer elektrischen Schaltung handeln kann.

Zwischen den Mastern 11, 12 und den Slaves 13, 14 ist ein Bussystem 15 vorhanden, das im vorliegenden Ausführungsbeispiel zur seriellen und synchronen Übertragung von elektrischen Signalen geeignet ist.

Beide Master 11, 12 sind dazu geeignet, ein Taktsignal SCLK (SCLK = serial clock) zu erzeugen und über eine SCLK-Leitung zu versenden. Die beiden von den Mastern 11, 12 kommenden SCLK-Leitungen sind miteinander verbunden und an beide Slaves 13, 14 angeschlossen. Die beiden Slaves 13, 14, sind dazu geeignet, das Taktsignal SCLK zu empfangen und zu verarbeiten.

Beide Master 11, 12 sind dazu geeignet, ein Master-Datensignal MO (MO = master out) zu erzeugen und über eine MO-Leitung zu versenden. Die beiden von den Mastern 11, 12 kommenden MO-Leitungen sind miteinander verbunden und an beide Slaves 13, 14 angeschlossen. Die beiden Slaves 13, 14 sind dazu geeignet, das MO-Signal zu empfangen und zu verarbeiten.

Beide Master 11, 12 sind dazu geeignet, ein Auswahlsignal CS1 (CSO = chip select) zu erzeugen und über eine CS1-Leitung zu versenden. Die beiden von den Mastern 11, 12 kommenden CS1-Leitungen sind miteinander verbunden und an einen der beiden Slaves 13, 14 angeschlossen. Dieser Slaves 13 ist dazu geeignet, das CS1-Signal zu empfangen und zu verarbeiten.

Beide Master 11, 12 sind dazu geeignet, ein Auswahlsignal CS2 (CSO = chip select) zu erzeugen und über eine CS2-Leitung zu versenden. Die beiden von den Mastern 11, 12 kommenden CS2-Leitungen sind miteinander verbunden und an den anderen der beiden Slaves 13, 14 angeschlossen. Dieser Slaves 14 ist dazu geeignet, das CS2-Signal zu empfangen und zu verarbeiten.

An den Ausgängen der beiden Master 11, 12, an denen das Taktsignal SCLK, das Master-Datensignal MO und die Auswahlsignale CS1, CS2 vorhanden sind, sind sogenannte Tri-State-Gatter 16 in die jeweiligen SCLK-, MO-, CS1- und CS2-Leitungen zwischengeschaltet. Die Tri-State-Gatter 16₁₁ sind dem Master 11 und die Tri-State-Gatter 16₁₂ sind dem Master 12 zugeordnet. Bei diesen Tri-State-Gattern 16 handelt es sich um digitale Bauteile, die einen Eingang und einen Ausgang aufweisen, und deren Ausgang in Abhängigkeit von einem sogenannten Enable-Signal zwei Zustände aufweisen kann. Ist das Enable-Signal beispielsweise "high bzw. 1 ", so entspricht der Ausgang dem Eingang des Tri-State-Gatters 16. In diesem Fall wirkt das Tri-State-Gatter 16 wie ein geschlossener Schalter. Ist das Enable-Signal jedoch "low bzw. 0", so wird der Ausgang des Tri-State-Gatters 16 vorzugsweise hochohmig geschaltet. In diesem Fall wirkt das Tri-State-Gatter 16 wie ein geöffneter Schalter.

Durch die Tri-State-Gatter 16 kann erreicht werden, dass die von den beiden Mastern 11, 12 erzeugten und gesendeten Signale keinen Einfluss auf den jeweils anderen Master 12, 11 haben. Wird beispielsweise von einem der beiden oder von beiden Mastern 11, 12 das Taktsignal SCLK versendet, so kann das dem einen Master 11 zugeordnete Tri-State-Gatter 16₁₁ derart geschaltet werden, dass es als geschlossener Schalter wirkt, während das dem anderen Master 12 zugeordnete Tri-State-Gatter 16₁₂ derart geschaltet wird, dass es als geöffneter Schalter wirkt. Damit besteht keine Verbindung mehr zwischen den Ausgängen der beiden Master 11, 12, auf denen jeweils das Taktsignal SCLK versendet wird. Die zwischen den beiden Mastern 11, 12 an sich verbundene SCLK-Leitung wird auf diese Weise durch eines der beiden Tri-State-Gatter 16 unterbrochen.

Beide Slaves 13, 14 sind dazu geeignet, ein Slave-Datensignal SO (SO = slave out) zu erzeugen und über eine SO-Leitung zu versenden. Die beiden von den Slaves 13, 14 kommenden SO-Leitungen sind miteinander verbunden und an beide Master 11, 12 angeschlossen. Die beiden Master 11, 12 sind dazu geeignet, das SO-Signal zu empfangen und zu verarbeiten. In den SO-Leitungen sind vorzugsweise keine Tri-State-Gatter enthalten.

Die elektrische Schaltung der Figur 1 weist einen Schaltungsteil 18 auf, der unter anderem dazu vorgesehen ist, das Enable-Signal für die Tri-State-Gatter 16 zu erzeugen. Eine beispielhafte Ausgestaltung des Schaltungsteils 18 geht aus der Figur 2 hervor.

Dem Schaltungsteil 18 ist ein CS-Signal als Eingangssignal zugeführt. Dieses CS-Signal wird von einem UND-Gatter 19 erzeugt, das eingangsseitig von den beiden Auswahlsignalen CS1, CS2 beaufschlagt ist. Das CS-Signal ist nur dann "high bzw. 1", wenn keines der beiden Auswahlsignale CS1, CS2 aktiv ist. Ansonsten ist das CS-Signal "low bzw. 0". Es wird darauf hingewiesen, dass im vorliegenden Ausführungsbeispiel angenommen wird, dass die Auswahlsignale CS1, CS2 in ihrem inaktiven Zustand "high bzw. 1" sind.

Gemäß der Figur 2 weist der Schaltungsteil 18 zwei NAND-Gatter 21, 22 auf, denen jeweils das CS-Signal als Eingangssignal zugeführt ist. Weiterhin ist den beiden NAND-Gattern 21, 22 ein Anforderungssignal REQ als Eingangssignal zugeführt, das von einem der beiden Master 11, 12, vorliegend von dem Master 11 erzeugt wird. Bei einem der beiden NAND-Gatter 21, vorliegend bei dem NAND-Gatter 22, wird dabei das Anforderungssignal REQ eingangsseitig invertiert.

Das Anforderungssignal REQ wird, wie erwähnt, von dem Master 11 erzeugt und dort ausgangsseitig zur Verfügung gestellt. Wird das Anforderungssignal REQ von dem Master 11 auf "high bzw. 1" gesetzt, so fordert der Master 11 den Zugriff auf das Bussystem 15 an. Der andere Master 12 kann kein derartiges Anforderungssignal REQ erzeugen. Statt dessen erhält der Master 12 nur dann den Zugriff auf das Bussystem 15, wenn der Master 11 den Zugriff auf das Bussystem 15 nicht anfordert. Insoweit ist der Master 11 dem Master 12 übergeordnet.

Das NAND-Gatter 21 erzeugt ausgangsseitig ein Set-Signal, das nur dann "low bzw. 0" ist, wenn das CS-Signal und das Anforderungssignal REQ "high bzw. 1" sind. Ansonsten ist das Set-Signal immer "high bzw. 1". Das NAND-Gatter 22 erzeugt ausgangsseitig ein Reset-Signal, das nur dann "low bzw. 0" ist, wenn das CS-Signal "high bzw. 1" und das Anforderungssignal REQ "low bzw. 0" ist. Ansonsten ist das Reset-Signal immer "high bzw. 1 ".

Das Set-Signal und das Reset-Signal sind einem S- und einem R-Eingang eines Flipflops 24 zugeführt. Ausgangsseitig erzeugt das Flipflop 24 das Enable-Signal, und zwar in der Form eines nicht-invertierten Enable-Signals EN und eines invertierten Enable-Signals EN*. Bei einem Übergang des S-Eingangs des Flipflops 24 auf "low bzw. 0" wird das Enable-Signal EN auf "high bzw. 1" und das invertierte Enable-Signal EN* auf "low bzw. 0" gesetzt. Bei einem Übergang des R-Eingangs des Flipflops 24 auf "low bzw. 0" wird das Enable-Signal EN auf "low bzw. 0" und das invertierte Enable-Signal EN* auf "high bzw. 1" gesetzt.

Das nicht-invertierte Enable-Signal EN beaufschlagt den Master 11 und diejenigen Tri-State-Gatter 16₁₁, die an den Ausgängen des Masters 11 vorhanden und damit dem Master 11 zugeordnet sind. Das invertierte Enable-Signal EN* beaufschlagt den Master 12 und diejenigen Tri-State-Gatter 16₁₂, die an den Ausgängen des Masters 12 vorhanden und damit dem Master 12 zugeordnet sind.

Ist das nicht-invertierte Enable-Signal EN "high bzw. 1 ", so hat der Master 11 Zugriff auf das Bussystem 15. Dies ergibt sich daraus, dass die dem Master 11 zugeordneten Tri-State-Gatter 16₁₁ als geschlossene Schalter wirken, während die dem Master 12 zugeordneten Tri-State-Gatter 16₁₂ als geöffnete Schalter wirken. Weiterhin erkennt der Master 11 diesen Zustand der Tri-State-Gatter 16 an dem ihm zugeführten und auf "high bzw. 1" stehenden, nicht-invertierten Enable-Signal EN, während der Master 12 den Zustand an dem ihm zugeführten und auf "low bzw. 0" stehenden, invertierten Enable-Signal EN* erkennt. Der Master 11 "weiß" somit, dass er auf das Bussystem 15 zugreifen kann, während der Master 12 "weiß", dass er keinen Zugriff auf das Bussystem 15 hat.

Ist das nicht-invertierte Enable-Signal EN "low bzw. 0" so ergibt sich ein umgekehrter Zustand, in dem der Master 11 keinen Zugriff und der Master 12 den Zugriff auf das Bussystem 15 hat.

Die dem Master 11 zugeordneten Tri-State-Gatter 16₁₁ und die dem anderen Master 12 zugeordneten Tri-State-Gatter 16₁₂ sind also immer gegensinnig geschaltet, so dass immer die dem einen der beiden Master 11, 12 zugeordneten Tri-State-Gatter 16 als geschlossene Schalter und die dem anderen der beiden Master 12, 11 zugeordnete Tri-State-Gatter 16 als geöffneter Schalter wirken.

Im Betrieb der elektrischen Schaltung 10 der Figur 1 fordert der Master 11 den Zugriff auf das Bussystem 15 dadurch an, dass er das Anforderungssignal REQ auf "high bzw. 1" setzt. Sobald beide Auswahlsignale CS1, CS2 inaktiv sind, sobald also das Bussystem 15 frei ist und damit vorhergehende Übertragungen über das Bussystem 15 abgeschlossen sind, wird das nicht-invertierte Enable-Signal EN auf "high bzw. 1" gesetzt. Damit wirken die dem Master 11 zugeordneten Tri-State-Gatter 16₁₁ als geschlossene Schalter, während die dem Master 12 zugeordneten Tri-State-Gatter 16₁₂ geöffnete Schalter darstellen. Weiter "weiß" der Master 11 aufgrund des empfangenen Enable-Signals EN, dass er auf das Bussystem 15 zugreifen kann. Der Master 11 wählt nunmehr einen der beiden Slaves 13, 14 mit Hilfe der Auswahlsignale CS1, CS2 als Empfänger aus. Dann versendet der Master 11 das Taktsignal SCLK und das Master-Datensignal MO. Der ausgewählte Slave empfängt das Master-Datensignal MO im Takt des Taktsignals SCLK. Weiterhin kann der ausgewählte Slave das Slave-Datensignal SO an den Master 11 zurücksenden. Sobald der Master 11 keinen Zugriff mehr auf das Bussystem 15 benötigt, setzt er das Anforderungssignal REQ auf "low bzw. 0". Danach kann der andere Master 12 in entsprechender Weise so lange auf das Bussystem 15 zugreifen, bis der Master 11 wieder das Anforderungssignal REQ auf "high bzw. 1" setzt.

Es versteht sich, dass der vorstehend erläuterte Betrieb der Schaltung 10 auch mit nur einem einzigen Slave möglich ist. In diesem Fall dient das Auswahlsignal nur noch dazu, das Ende einer Übertragung von Signalen über das Bussystem 15 anzuzeigen.

Bei der Schaltung 10 der Figur 1 ist eine Übertragung von Signalen zwischen den beiden Mastern 11, 12 nicht möglich. Dies wird, wie erläutert wurde, durch die Tri-State-Gatter 16 unterbunden.

Soll nunmehr eine Übertragung von Signalen zwischen den beiden Mastern 11, 12 möglich sein, so kann dies dadurch erreicht werden, dass der in der Figur 1 als gestrichelter Block hervorgehobene Schaltungsteil 30 gemäß den Figuren 3a, 3b abgewandelt wird.

In der Figur 3a ist der Master 11 mit den erläuterten Signalen dargestellt. Zusätzlich zu den Tri-State-Gattern 16₁₁ sind dem Master 11 weitere Tri-State-Gatter 31 zugeordnet, die den einzelnen Tri-State-Gattern 16₁₁ jeweils gegensinnig parallel geschaltet sind. Die Tri-State-Gatter 16 werden wie bisher von dem nicht-invertierten Enable-Signal EN angesteuert, während die zusätzlichen Tri-State-Gatter 31 von dem invertierten Enable-Signal EN* beaufschlagt werden. Letzteres geht aus der Figur 3a dadurch hervor, dass der dem Enable-Signal EN zugehörige Eingang der Tri-State-Gatter 31 invertiert ist.

Hat der Master 11 den Zugriff auf das Bussystem 15, so wirken die zusätzlichen Tri-State-Gatter 31 als geöffnete Schalter. In diesem Fall entspricht die Funktionsweise der Schaltung der Figur 3a den Erläuterungen zur Figur 1. Hat jedoch der Master 12 den Zugriff auf das Bussystem 15, so wirken die Tri-State-Gatter 16 als geöffnete Schalter und die zusätzlichen Tri-State-Gatter 31 als geschlossene Schalter. Die von dem Master 12 auf dem Bussystem 15 übertragenen Signale gelangen somit auch zu dem Master 11. Sofern der Master 11 zum Empfangen dieser Signale in der Lage ist, so kann der Master 11 nunmehr die von dem anderen Master 12 auf dem Bussystem 15 übertragenen Signale über die zusätzlichen Tri-State-Gatter 31 einlesen und verarbeiten.

Damit der Master 11 in der Lage ist, Signale vom Bussystem 15 zu empfangen, kann es erforderlich sein, eine entsprechende Umstellung des Masters 11 vorzunehmen. Diese Umstellung kann von dem dem Master 11 zugeführten Enable-Signal EN gesteuert werden.

In der Figur 3b wird davon ausgegangen, dass bei dem Master 11 an dessen Ausgängen jeweils zwei antiparallel geschaltete Tri-State-Gatter 33 vorhanden sind. In diesem Fall können diese Tri-State-Gatter 33 innerhalb des Masters 11 per Software in Abhängigkeit von dem zugeführten Enable-Signal EN in entsprechender Weise gesteuert werden, wie dies für die Tri-State-Gatter 16, 31 der Figur 3a erläutert wurde. Letzteres ist in der Figur 3b mit Hilfe eines Pfeils 34 angedeutet. Auf diese Weise kann erreicht werden, dass der Master 11 die von dem Master 12 auf dem Bussystem 15 übertragenen Signale einlesen und verarbeiten kann.

Es versteht sich, dass auch der Master 12 mit entsprechenden zusätzlichen Tri-State-Gattern versehen werden kann, so dass auch der Master 12 die von dem Master 11 auf dem Bussystem 15 übertragenen Signale einlesen und verarbeiten kann.

## Patentansprüche

1. Elektrische Schaltung (10), umfassend zwei Master (11, 12) und einen oder mehrere Slaves (13, 14), eingerichtet zur Übertragung von Signalen zwischen zwei Mastern (11, 12) und einem oder mehreren Slaves (13, 14), wobei die beiden Master (11, 12) und der oder die Slaves (13, 14) über ein Bussystem (15) miteinander verbunden sind, wobei jeder der beiden Master (11, 12) dazu eingerichtet ist, jeweils zumindest ein Master-Datensignal (MO) zu erzeugen und über eine MO-Leitung zu versenden, wobei die beiden von den Mastern (11, 12) kommenden MO-Leitungen miteinander verbunden und an den oder die Slaves (13, 14) angeschlossen sind und das Master-Datensignal (MO) von dem oder den Slaves (13, 14) empfangen werden kann, wobei an den Ausgängen der beiden Master (11, 12), an denen das jeweilige Master-Datensignal (MO) anliegt, jeweils ein Tri-State-Gatter (16) vorhanden ist,
wobei die Tri-State-Gatter (16) entweder als geschlossene oder als geöffnete Schalter wirksam sind, und wobei die Tri-State-Gatter (16) derart angesteuert werden, dass das dem einen der beiden Master (11) zugeordnete Tri-State-Gatter (1611) als geschlossener Schalter und das dem anderen der beiden Master (12) zugeordnete Tri-State-Gatter (1612) als geöffneter Schalter wirkt,
**dadurch gekennzeichnet, dass** von den beiden Mastern (11, 12) jeweils zumindest ein Auswahlsignal (CS1, CS2) erzeugt wird, das von dem oder den Slaves (13, 14) empfangen wird, und durch welches der Slave oder
einer der Slaves als Empfänger ausgewählt wird,
wobei an den Ausgängen der beiden Master (11, 12), an denen das jeweilige Auswahlsignal anliegt, jeweils ein Tri-State-Gatter (16) vorhanden ist, wobei die Tri-State-Gatter (16) in Abhängigkeit von einem Anforderungssignal (REQ) angesteuert werden, das von einem der beiden Master (11, 12) erzeugt wird, wenn dieser Master (11, 12) Signale auf dem Bussystem übertragen will,
und dass die elektrische Schaltung ein Schaltungsteil (18) umfasst, durch welches die Tri-State-Gatter (16) in Abhängigkeit von dem jeweils zumindest einen Auswahlsignal (CS1, CS2) und dem Anforderungssignal (REQ) angesteuert werden, so dass eine Vergabe des Zugriffs auf das Bussystem nur dann möglich ist, wenn die jeweiligen Auswahlsignale (CS1, CS2) der beiden Master inaktiv sind und damit eine vorhergehende Übertragung auf dem Bussystem beendet ist.

2. Elektrische Schaltung (10) nach Anspruch 1, wobei von den beiden Mastern (11, 12) jeweils ein Taktsignal (SCLK) erzeugbar ist, das von dem oder den Slaves (13, 14) empfangen werden kann, und wobei an den Ausgängen der beiden Master (11, 12), an denen das jeweilige Taktsignal anliegt, jeweils ein Tri-State-Gatter (16) vorhanden ist.

3. Elektrische Schaltung (10) nach Anspruch 1 oder 2, wobei dem Schaltungsteil (18) das Anforderungssignal (REQ) und ein verknüpftes Signal (CS) als Eingangssignal zugeführt werden, wobei das verknüpfte Signal (CS) aus einer logischen Verknüpfung der Auswahlsignale (CS1, CS2) entsteht.

4. Elektrische Schaltung nach einem der Ansprüche 1 bis 3, wobei im Schaltungsteil (18) abhängig von dem Anforderungssignal (REQ) und dem verknüpften Signal (CS) zwei Enable-Signals (EN, EN*) generiert werden, wobei das erste Enable Signal (EN) den Tri-State Gattern (1611), die dem einen Master (11) zugeordnet sind, zugeführt wird, und das zweite Enable-Signal (EN*) den Tri-State-Gattern (1612), die dem anderen Master (12) zugeordnet sind, zugeführt wird.

5. Elektrische Schaltung (10) nach einem der vorstehenden Ansprüche, wobei die Tri-State-Gatter (16) in Abhängigkeit davon angesteuert werden, ob eine Übertragung auf dem Bussystem (15) stattfindet oder nicht.

6. Elektrische Schaltung (10) nach einem der vorstehenden Ansprüche, wobei den Tri-State-Gattern (16) jeweils ein gegensinnig geschaltetes Tri-State-Gatter (31) parallel geschaltet ist, und wobei die gegensinnig parallel geschalteten Tri-State-Gatter (31) in invertierter Weise zu den Tri-State-Gattre (16) angesteuert werden.

7. Elektrische Schaltung (10) nach einem der vorstehenden Ansprüche, **gekennzeichnet durch** deren Verwendung im Zusammenhang mit einem elektronischen Steuergerät eines Kraftfahrzeugs.

## Claims

1. Electrical circuit (10) comprising two masters (11, 12) and one or more slaves (13, 14), set up to transmit signals between two masters (11, 12) and one or more slaves (13, 14), wherein the two masters (11, 12) and the slave(s) (13, 14) are connected to one another via a bus system (15), wherein each of the two masters (11, 12) is set up to respectively produce at least one master data signal (MO) and to send it via an MO line, wherein the two MO lines coming from the masters (11, 12) are connected to one another and connected to the slave(s) (13, 14) and the master data signal (MO) can be received by the slave (s) (13, 14), wherein a respective tristate gate (16) is present at the outputs of the two masters (11, 12) to which the respective master data signal (MO) is applied,
wherein the tristate gates (16) are active either as closed or as open switches, and wherein the tristate gates (16) are actuated such that the tristate gate (1611) associated with one of the two masters (11) acts as a closed switch and the tristate gate (1612) associated with the other of the two masters (12) acts as an open switch, **characterized in that** the two masters (11, 12) each produce at least one selection signal (CS1, CS2) that is received by the slave(s) (13, 14) and that selects the slave or one of the slaves as a receiver,
wherein a respective tristate gate (16) is present at the outputs of the two masters (11, 12) to which the respective selection signal is applied, wherein the tristate gates (16) are actuated on the basis of a request signal (REQ) that is produced by one of the two masters (11, 12) when this master (11, 12) wishes to transmit signals on the bus system,
and **in that** the electrical circuit comprises a circuit portion (18) that actuates the tristate gates (16) on the basis of the respective at least one selection signal (CS1, CS2) and the request signal (REQ), so that access to the bus system can be allocated only when the respective selection signals (CS1, CS2) of the two masters are inactive and hence a preceding transmission on the bus system has terminated.

2. Electrical circuit (10) according to Claim 1, wherein the two masters (11, 12) can each produce a clock signal (SCLK) that can be received by the slave(s) (13, 14), and wherein a respective tristate gate (16) is present at the outputs of the two masters (11, 12) to which the respective clock signal is applied.

3. Electrical circuit (10) according to Claim 1 or 2, wherein the circuit portion (18) is supplied with the request signal (REQ) and a logically combined signal (CS) as input signal, wherein the logically combined signal (CS) is produced from a logic combination of the selection signals (CS1, CS2).

4. Electrical circuit according to one of Claims 1 to 3, wherein two enable signals (EN, EN*) are generated in the circuit portion (18) on the basis of the request signal (REQ) and the logically combined signal (CS), wherein the first enable signal (EN) is supplied to the tristate gates (1611) that are associated with one master (11) and the second enable signal (EN*) is supplied to the tristate gates (1612) that are associated with the other master (12).

5. Electrical circuit (10) according to one of the preceding claims, wherein the tristate gates (16) are actuated on the basis of whether or not a transmission on the bus system (15) takes place.

6. Electrical circuit (10) according to one of the preceding claims, wherein the tristate gates (16) each have a reverse-connected tristate gate (31) connected in parallel with them, and wherein the reverse-connected parallel tristate gates (31) are actuated inversely with respect to the tristate gates (16).

7. Electrical circuit (10) according to one of the preceding claims, **characterized by** use thereof in connection with an electronic controller of a motor vehicle.

## Revendications

1. Circuit électrique (10), comprenant deux maîtres (11, 12) et un ou plusieurs esclaves (13, 14), conçu pour la transmission de signaux entre deux maîtres (11, 12) et un ou plusieurs esclaves (13, 14), les deux maîtres (11, 12) et le ou les esclaves (13, 14) étant reliés ensemble par le biais d'un système de bus (15), chacun des deux maîtres (11, 12) étant conçu pour générer à chaque fois au moins un signal de données de maître (MO) et pour l'envoyer par le biais d'une ligne MO, les deux lignes MO en provenance des maîtres (11, 12) étant reliées ensemble et raccordées à l'esclave ou aux esclaves (13, 14) et le signal de données de maître (MO) pouvant être reçu par le ou les esclaves (13, 14), une porte à trois états (16) étant respectivement présente aux sorties des deux maîtres (11, 12) sur lesquelles est présent le signal de données de maître (MO) correspondant,
les portes à trois états (16) faisant office de commutateur soit ouvert, soit fermé, et les portes à trois états (16) étant commandées de telle sorte que la porte à trois états (1611) associée à l'un des deux maîtres (11) fait office de commutateur fermé et la porte à trois états (1612) associée à l'autre des deux maîtres (12) fait office de commutateur ouvert, **caractérisé en ce qu'**au moins un signal de sélection (CS1, CS2) est à chaque fois généré par les deux maîtres (11, 12), lequel est reçu par le ou les esclaves (13, 14) et par le biais duquel l'esclave ou l'un des esclaves est sélectionné en tant que destinataire,
une porte à trois états (16) étant respectivement présente aux sorties des deux maîtres (11, 12) sur lesquelles est présent le signal de sélection,
les portes à trois états (16) étant commandées en fonction d'un signal de demande (REQ) qui est généré par l'un des deux maîtres (11, 12) lorsque ce maître (11, 12) veut transmettre des signaux sur le système de bus,
et **en ce que** le circuit électrique comprend une partie de circuit (18) par laquelle les portes à trois états (16) sont commandées en fonction de l'au moins un signal de sélection (CS1, CS2) correspondant et du signal de demande (REQ), de sorte qu'un octroi de l'accès au système de bus n'est possible que lorsque les signaux de sélection (CS1, CS2) respectifs des deux maîtres sont inactifs et qu'une transmission précédente sur le système de bus est ainsi terminée.

2. Circuit électrique (10) selon la revendication 1, dans lequel un signal d'horloge (SCLK) peut à chaque fois être généré par les deux maîtres (11, 12), lequel peut être reçu par le ou les esclaves (13, 14), et dans lequel une porte à trois états (16) est respectivement présente aux sorties des deux maîtres (11, 12) auxquelles est présent le signal d'horloge correspondant.

3. Circuit électrique (10) selon la revendication 1 ou 2, dans lequel un signal de demande (REQ) et un signal combiné (CS) sont acheminés à la partie de circuit (18) sous la forme d'un signal d'entrée, le signal combiné (CS) étant produit par une combinaison logique des signaux de sélection (CS1, CS2).

4. Circuit électrique selon l'une des revendications 1 à 3, dans lequel deux signaux d'activation (EN, EN*) sont générés dans la partie de circuit (18) en fonction du signal de demande (REQ) et du signal combiné (CS), le premier signal d'activation (EN) étant acheminé aux portes à trois états (1611) qui sont associées à l'un des maîtres (11) et le deuxième signal d'activation (EN*) étant acheminé aux portes à trois états (1612) qui sont associées à l'autre maître (12).

5. Circuit électrique (10) selon l'une des revendications précédentes, dans lequel les portes à trois états (16) sont commandées en fonction du fait qu'une transmission ait lieu ou non sur le système de bus (15).

6. Circuit électrique (10) selon l'une des revendications précédentes, dans lequel les portes à trois états (16) sont respectivement branchées en parallèle avec une porte à trois états (31) branchée en sens inverse, et dans lequel les portes à trois états (31) branchées en parallèle en sens inverse sont commandées de manière inversée par rapport aux portes à trois états (16).

7. Circuit électrique (10) selon l'une des revendications précédentes, **caractérisé par** son utilisation en association avec un contrôleur électronique d'un véhicule automobile.
